Europäisches Patentamt

European Patent Office

Office européen des brevets

(19)

(11) Numéro de publication: **0 1 1 3 6 1 1**
**B1**

(12) **FASCICULE DE BREVET EUROPEEN**

(45) Date de publication du fascicule du brevet:
19.03.86

(51) Int. Cl.⁴: **H 03 C  3/09**, H 03 C  3/02

(21) Numéro de dépôt: 83402325.1

(22) Date de dépôt: 02.12.83

(54) **Dispositif de linéarisation automatique de la caractéristique fréquence-signal de commande, d'un oscillateur à fréquence variable modulé en fréquence.**

(30) Priorité: 14.12.82 FR 8220967

(43) Date de publication de la demande:
18.07.84 Bulletin 84/29

(45) Mention de la délivrance du brevet:
19.03.86 Bulletin 86/12

(84) Etats contractants désignés:
**DE GB**

(56) Documents cités:
**EP - A - 0 033 256**
**FR - A - 2 462 056**
**US - A - 3 396 340**
**US - A - 4 027 264**

(73) Titulaire: **THOMSON-CSF, 173, Boulevard Haussmann,**
**F-75379 Paris Cedex 08 (FR)**

(72) Inventeur: **Parniere, Alain, THOMSON-CSF SCPI 173, bld**
**Haussmann, F-75379 Paris Cedex 08 (FR)**
Inventeur: **Bazenant, Dominique, THOMSON-CSF**
**SCPI 173, bld Haussmann, F-75379 Paris Cedex 08 (FR)**

(74) Mandataire: **Lincot, Georges et al, THOMSON-CSF**
**SCPI 19, avenue de Messine, F-75008 Paris (FR)**

LIBER, STOCKHOLM 1986

## Description

La présente invention concerne un dispositif de linéarisation automatique de la caractéristique fréquence-signal de commande, d'un oscillateur à fréquence variable modulé en fréquence, le signal de commande pouvant être indifféremment un signal d'amplitude variable ou constante constitué par un niveau de tension électrique ou un niveau de courant électrique applique sur l'entrée de commande de l'oscillateur.

Les oscillateurs à fréquence variable commandée par un signal sont connus et sont souvent utilisés pour réaliser des synthétiseurs de fréquence à haute pureté spectrale et à grande résolution. Les synthétiseurs de fréquence remplacent avantageusement les générateurs de frequence pilotes à quartz à fréquence fixe des oscillateurs locaux associés à des multiplicateurs de fréquence car, ils permettent d'accroître l'agilité de fréquence des faisceaux hertziens et des liaisons spatiales en particulier. En effet, il est plus simple et plus économique de moduler directement les synthétiseurs en modulation de fréquence, soit par un multiplex analogique, soit par un train numérique, que d'avoir recours à des modulateurs de fréquence indépendants à fréquence fixe, suivis d'une transposition de fréquence, a l'aide, d'un signal hétérodyne issu d'un synthétiseur non module.

La realisation des synthétiseurs à modulation de fréquence pour émetteurs radioélectriques présente toutefois certaines difficultés qu'il est nécessaire de surmonter. En effet, il est souhaitable, dans la plupart des applications, pour avoir un fonctionnement correct des récepteurs que le rapport signal à bruit de l'onde reçue après démodulation conserve une valeur constante et, cette contrainte se traduit par la nécessité de maintenir au niveau de l'émission un indice de modulation de frequence constant pour pouvoir démoduler au niveau des récepteurs une onde modulée à indice constant quelque soit la fréquence du canal de liaison. Par conséquent, le principe de moduler en fréquence directement le synthétiseur, implique pour satisfaire l'exigence precedente, que la pente de la caractéristique fréquence-tension ou fréquence-courant de l'oscillateur à fréquence variable utilisée soit aussi constante que possible à l'intérieur de la plage de variation utile pour que l'indice de modulation du signal modulé en fréquence conserve une valeur à peu pres constante. Or cet impératif n'est malheureusement pas réalisé pour la piupart des oscillateurs à fréquence variable commandés par la tension, à cause notamment, de la caractéristique propre des diodes à capacité variable du type "varicaps" utilisées pour accorder l'oscillateur sur sa fréquence de fonctionnement et pour réaliser une modulation en fréquence de celle-ci.

Ce problème a déjà été résolu par le passé, en corrigeant la caractéristique fréquence-tension de commande de l'oscillateur à fréquence variable à l'aide d'un dispositif de linéarisation à diodes, obtenu en synthétisant la caractéristique inverse de la caractéristique frequence tension de l'oscillateur à fréquence variable, par approximations successives à l'aide d'un réseau à diodes. Pour des bandes de fréquences de fonctionnement relativement importantes, cette solution conduit à des correcteurs à grand nombre de segments et la reproductibilité de tels oscillateurs à fréquence variable linéarisés est souvent délicate et nécessite des ajustements importants à cause des dispersions des caractéristiques électriques des diodes utilisées.

On connaît également une autre solution qui consiste à réaliser les synthétiseurs de fréquence à l'aide d'oscillateurs YIG dont la caractéristique fréquence-courant de commande est très linéaire mais qui présentent l'inconvénient d'être encore extrêmement onéreux. On rappelle ici pour mémoire que l'abréviation YIG correspond à la contraction du terme anglais Yttrium Indium Garnet. L'oscillateur YIG utilise le phénomène de resonance gyromagnetique du cristal et sa fréquence de fonctionnement est ajustée à l'aide du champ magnétique appliqué au travers du cristal.

Le but de l'invention est de palier les inconvénients précités.

A cet effet, l'invention a pour objet un dispositif de linéarisation automatique de la caractéristique fréquence-signal de commande, d'un oscillateur à fréquence variable modulé en fréquence, dans lequel, la fréquence de fonctionnement de l'oscillateur est obtenue à partir d'un signal de commande appliqué sur l'entrée de commande de l'oscillateur et la fréquence de modulation est obtenue à partir d'un signal modulant dont l'amplitude est ajustée, par des moyens d'ajustement, en fonction de l'indice de modulation du signal module en fréquence souhaité, le signal modulant étant ajouté au signal de commande pour obtenir en sortie de l'oscillateur un signal modulé en fréquence, comme conna par le document FR-A-2 462 056; le dispositif de l'invention est caractérisé en ce qu'il comprend, une boucle a verrouillage de phase ayant une entrée de consigne sur laquelle est appliqué un signal correspondant au signal modulé en frequence fourni par l'oscillateur et dont la bande passante est réglée pour obtenir sur sa sortie un signal filtré en fréquence correspondant au signal modulé en fréquence appliqué sur l'entrée de consigne débarrassé de la fréquence de modulation; un démodulateur de phase couple par une première et une deuxième entrée respectivement, à l'entrée de consigne et a la sortie de la boucle de verrouillage de phase pour engendrer un signal correspondant à l'indice de modulation du signal modulé en fréquence obtenue à la sortie de l'oscillateur; ainsi qu'un circuit comparateur couplé par une première entrée à la sortie du démodulateur dephase et sur la deuxieme entrée duquel est appliqué un signal de référence correspondant à l'indice de modulation souhaité, pour obtenir, en sortie du comparateur, un signal de commande des moyens d'ajustement de l'amplitude du signal modulant de façon à ajuster en permanence l'indice de modulation du signal modulé en fréquence produit à la sortie de l'oscillateur à la valeur de l'indice de modulation souhaité.

Le dispositif selon l'invention a pour avantage qu'il permet de linéariser automatiquement un oscillateur à fréquence variable controlé en fréquence, dont la caractéristique fréquence tension de commande ou fréquence courant de commande peut être quelconque sur une bande relative de fréquence importante. Cette solution autorise la modulation directe des synthétiseurs en modulation de fréquence, soit par un multiplex analogique, soit par un multiplex numérique. Par rapport au dispositif à linéarisation à diodes, le dispositif selon l'invention ne nécessite aucun réglage particulier ce qui en facilite grandement l'industrialisation. En outre la simplicité de réalisation du dispositif selon l'invention ne meten oeuvre que peu de composants electroniques supplémentaires et est par conséquent peu onéreuse.

D'autres caractéristiques et avantages de l'invention apparaîtront au cours de la description faite au regard des dessins annexés donnés uniquement à titre d'exemple et dans lesquels:
- la figure 1 représente un schéma de principe du dispositif de linéarisation automatique selon l'invention,
- la figure 2 est une représentation détaillée du dispositif représenté à la figure 1.

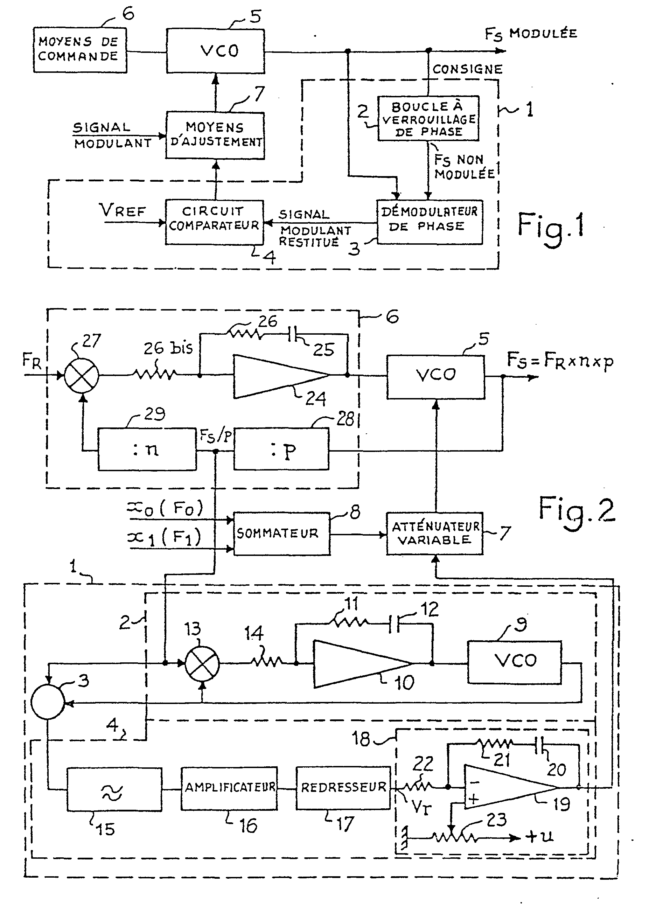

Le dispositif selon l'invention représenté en 1 à la figure 1 comprend une boucle à verrouillage de phase 2, un démodulateur de phase 3 et un circuit comparateur 4. Un oscillateur à fréquence variable 5, relié au dispositif 1, est accordé sur sa fréquence de fonctionnement par les moyens de commande 6 et est modulé en fréquence par un signal modulant, appliqué sur une entrée de commande de modulation, au travers de moyens d'ajustement 7 destinés à régler l'amplitude du signal modulant appliqué à l'entrée de commande de modulation de l'oscillateur à fréquence variable 5, afin de maintenir constant l'indice de modulation du signal engendré par l'oscillateur 5. Le dispositif 1 est relié aux moyens d,ajustement 7 par l'intermédiaire du circuit comparateur 4 et est reliéà la sortie de l'oscillateur 5 par l'entrée de consigne de la boucle à verrouillage de phase 2 et par une première entrée du démodulateur de phase 3. Le signal de sortie de la boucle à verrouillage de phase 2 est asservi en phase sur le signal fourni par la sortie de l'oscillateur à fréquence variable 5 et sa fonction de transfert est déterminée de façon que son signal de sortie reproduise le signal d'entrée, tout en étant débarrassé de la fréquence de modulation du signal d'entrée. Le démodulateur 3 compare le signal non modulé appliqué sur sa première entrée par la sortie de la boucle à verrouillage de phase 2, au signal modulé appliqué sur sa deuxième entrée par la sortie de l'oscillateur à fréquence variable 5. De cette façon, le démodulateur de phase 3 restitue le signal modulant et l'applique sur la première entrée du circuit comparateur 4 qui le compare à un signal de référence VREF appliqué sur sa deuxième entrée et correspondant à la valeur de l'indice de modulation souhaite. La sortie du circuit de comparateur 4 fournit, a l'entrée de commande des moyens d'ajustement 5, un signal de commande dont la valeur correspond à l'écart de valeurs du signal modulant et du signal de référence VREF, pour permettre à la boucle d'asservissement, constituée par l'oscillateur à fréquence variable 5 et les éléments du dispositif de linéarisation 1de réagir pour annuler l'écart entre le signal modulant et le signal de référence VREF détecté par le circuit comparateur 4. Lorsque cet écart est annulé, l'indice de modulation du signal modulé en fréquence engendre par l'oscillateur à fréquence variable 5 correspond à l'indice de modulation souhaité indiqué par le niveau du signal de référence VREF.

Une variante de réalisation du dispositif de la figure 1 est maintenant décrite à l'aide du schéma représenté à la figure 2. Sur cette figure les éléments similaires à ceux de la figure 1 sont repérés par les mêmes références. Comme sur Ja figure 1, le dispositif de linéarisation 1 comprend une boucle à verrouillage de phase 2 représentée à l'intérieur d'un rectangle en pointillés, un démodulateur de phase 3 et un circuit comparateur 4 représenté également à l'intérieur d'une ligne en pointillés. L'oscillateur à fréquence variable 5 est commandé à l'aide de moyens de commande 6 représentés à l'intérieur d'un rectangle en pointillés qui, dans le cas de la figure 2, sont composés par la boucle d'un synthétiseur de fréquence. Comme dans le cas de la figure 1, l'oscillateur à frequence variable 5 est commandé par le dispositif 1 au travers d'un atténuateur variable 7. Le signal modulant est appliqué à l'entrée de l'atténuateur variable 7 par la sortie d'un sommateur 8 qui dans le cas de la figure 2 a pour fonction d'additionner deux signaux sinusoïdaux $X_0$ et $X_1$ de frequences respectives $f_0$ et $f_1$, telles que $f_1$ maximum soit inférieureà $f_0$ et où $X_1$ représente par exemple, un signal de modulation fourni par un multiplex numérique, non représenté.

La boucle à verrouillage de phase 2 est constituée par un oscillateur à fréquence variable 9, commandé en tension par la sortie d'un intégrateur, composé par un amplificateur 10 dont l'entrée et la sortie sont reliées au moyen d'une résistance 11 et d'un condensateur 12 montés en série et dont l'entrée est également couplée à la sortie d'un discriminateur de phase 13 au travers d'une résistance 14. Le discriminateur de phase 13 a deux entrées, une première entrée reçoit un signal de consigne en provenance de l'oscillateur à fréquence variable 5, et la deuxième entrée reçoit le signal sortant de l'oscillateur à fréquence variable9 constituant la sortie de la boucle à verrouillage de phase 2. Comme dans le cas de la figure 1 le démodulateur de phase 3 reçoit le signal de consigne fourni par l'oscillateur à fréquence variable 5 sur une première entrée et le signal emis par la sortie de la boucle à verrouillage de phase 2 sur sa deuxième entrée. La sortie du démodulateur de phase 3 est appliquée à l'entrée du circuit comparateur 4 composé par, un filtre15, un amplificateur 16, un redresseur 17 et un intégrateur 18 montés en série. L'intégrateur 18 est formé par un amplificateur différentiel 19 dont la sortie est rebouclée sur l'entrée marquée "−" au moyen d'un condensateur 20 et d'une résistance 21 montés en série. L'entrée marquée "−"de l'amplificateur 19 est reliée à la sortie du redresseur 17 au moyen d'une résistance 22 et l'entrée marquée" +" de l'amplificateur 19 est reliée au curseur d'un potentiomètre 23 polarisé par une tension de polarisation +U constante pour faire apparaitre sur le curseur du potentiomètre 23 la tension de référence VREF correspondant à l'indice de modulation-souhaité. La sortie de l'amplificateur 19 est couplée à l'entrée de commande de l'atténuateur variable 7.

La boucle du synthétiseur de fréquence constituant les moyens de commande 6 comprend des moyens d'intégration formés par un amplificateur 24 dont la sortie est couplée à l'entrée au moyen d'un condensateur 25 et d'une résistance 26 montés en série. L'entrée de l'amplificateur24 est reliée à la sortie d'un discriminateur de phase/fréquence 27 au travers d'une résistance 26 bis. Le discriminateur 27 reçoit un signal de fréquence de référence $F_R$ sur une première entrée et est reliée par une deuxième entrée à la sortie de l'oscillateur à fréquence variable 5 au moyen d'un diviseur à rang fixe 28 et d'un diviseur à rang variable 29 montés en série. Si p désigne le rang de division du diviseur 28 et n le rang de division du diviseur variable 29, la fréquence de fonctionnement $F_S$ obtenue en sortie de l'oscillateur à fréquence variable 5 est égale à la fréquence de référence $F_R$ multipliée par le produit n.p des rangs de division des diviseurs 28 et 29. Le signal de consigne appliqué à la première entrée du discriminateur de phase 13 de la boucle à verrouillage de phase 2 et à la première entrée du démodulateur de phase 3 est prélevé à la sortiedu diviseur à rang fixe 28. De cette façon, le signal de consigne possèdeune fréquence égale à la fréquence $F_S$ du signal sortant de l'oscillateur 5 divisé par le rang p du diviseur 28. Le diviseur à rang variable 29 divisela la fréquence

$$\frac{F_s}{P}$$

du signal fourni par le diviseur 28 pour la transf ormer en une fréquence $F_S/n.p$ qui est comparée à la fréquence de référence $F_R$. Un signal d'erreur est fourni par le discriminateur 27 qui après amplification et filtrage par le circuit d'intégration comprenant l'amplificateur 24, permet d'asservir la fréquence de l'oscillateur à fréquence variable 5 sur la fréquence $F_S = F_R \times n \times p$.

La bande passante de la boucle du synthétiseur formant les moyens de commande 6 est suffisamment étroite pour permettre la modulation en fréquence directe de l'oscillateur à fréquence variable 5au travers de l'atténuateur variable 7 commandé en tension par le sommateur

8. Le signal de fréquence

$$\frac{F_s}{P}$$

obtenu à la sortie du diviseur 28 est luimême modulé en fréquence avec un indice de modulation qui est divisé par le rang p du diviseur 28. Comme il a été dit précédemment lors du fonctionnement de la figure 1, la boucle à verrouillage de phase 2 permet de supprimer cette modulation si la constante d'intégration de l'integrateur formé par l'amplificateur 10 est suffisamment grande pour conférer à la boucle à verrouillage de phase 2 une bande passante de boucle étroite.

Mais, dans l'exemple représenté à la figure 2, la boucle de verrrouillage de phase 2 a le rôle d'un filtre sélectif qui autorise une recopie du signal modulant $X_1$ et une élimination du signal modulant $X_0$. Ce résultat est atteint, en plaçant la fréquence de coupure de la bandeà verrouillage de phase 2, entre les deux fréquences $f_0$ et $f_1$ maximumdes signaux modulant $X_0$ et $X_1$ par action sur la constante d'intégrationde l'intégrateur de la boucle 2.

Dans ces conditions, la démodulation du signal

$$\frac{F_s}{P}$$

sortant du diviseur 28 est effectuée directement par le discriminateur de phase 3 qui reçoit sur sa première entrée le signal

$$\frac{F_s}{P}$$

modulé et sur sa deuxième entrée le signal

$$\frac{F_s}{P}$$

débarrasse de la fréquence de modulation $f_0$ obtenu en sortie de la boucle à verrouillage de phase 2. Le signal démodulé de fréquence $f_0$ correspondant au signal modulant $X_0$ sortant du discriminateur de phase 3 est filtré par le filtre 15, amplifié par l'amplificateur16 et redressé par le redresseur 17 pour fournir une tension $V_t$ continue image de l'indice de modulation du signal fourni par l'oscillateur à fréquence variable 5 modulé par le signal $X_0$.

La tension $V_t$ est comparée à la tension de référence VREF choisie et le signal d'erreur après amplification et filtrage par l'amplificateur 19, le condensateur 20 et les résistances 21 et 22, commande l'atténuateur variable 17 placé sur le chemin des signaux de modulation $X_0$ et $X_1$. Le réglage de l'indice de modulation s'effectue alors en ajustant la tension de consigne VREF sur l'entrée marquée "+" de l'amplificateur 19.

Dans l'exemple de réalisation de la figure 2 l'usage de deux signaux de modulation $X_0$ et $X_1$ est particulièrement intéressant dans le cas où l'oscillateur à fréquence variable 5 est destine a alimenter en fréquence un faisceau hertzien troposphérique à diversité de fréquence nécessitant par exemple l'émission simultanée de trois porteuses équidistantes d'amplitude égale. En effet, dans ce cas, l'élaboration de ces trois porteuses peut être faite directement par modulation de la fréquence de fonctionnement avec par un grand indice de modulation (m = 1,43) de la manière décrite par exemple dans la demande de brevet français N° 80 01898 déposée au nom de la Demanderesse. et publiéesons le N° FR-A-2 474 791 Dans ce cas le signal modulant $X_0$ permet de générer les trois raies, d'égales amplitudes, espacées de la fréquence $f_0$ et le signal utile de modulation $X_1$ permet de moduler chacune des trois raies.

Bien que les principes de la présente invention aient été décrits ci-dessus en relation avec un exemple particulier de réalisation, il faut comprendre que la description n'a été faite qu'à titre d'exemple et ne limite pas la portée de l'invention.

## Revendications

1. Dispositif de linéarisation automatique de la caractéristique fréquence-signal de commande, d'un oscillateur à fréquence variable (5) modulé en fréquence dans lequel, la fréquence de fonctionnement de l'oscillateur est obtenue à partir d'un signal de commande appliqué sur l'entrée de commande de l'oscillateur et la fréquence de modulation est obtenue à partir d'un signal modulant dont l'amplitude est ajustée par des moyens d'ajustement (7) en fonction de l'indice de modulation du signal modulé en fréquence souhaité, le signal modulant étant ajouté au signal de commande pour obtenir en sortie de l'oscillateur un signal modulé en fréquence, caractérisé en ce qu'il comprend, une boucle à verrouillage de phase (2) ayant une entrée de consigne sur laquelle est appliqué un signal correspondant au signal modulé en fréquence fourni par l'oscillateur (5) et dont la bande passante est réglée pour obtenir sur sa sortie un signal filtré en fréquence, correspondant au signal modulé en fréquence appliqué sur l'entrée de consigne débarrassé de la fréquence de modulation, un démodulateur de phase (3) couplé par une première et une deuxième entrée, respectivement, à l'entrée de consigne et à la sortie de la boucle de verrouillage de phase pour engendrer un signal correspondant à l'indice de modulation du signal modulé en fréquence obtenue à la sortie de l'oscillateur (5), ainsi qu'un circuit comparateur (4) couplé par une première entrée à la sortie du démodulateur de phase (3) et sur une deuxième entrée duquel est appliqué un signal de référence VREF, correspondant à l'indice de modulation souhaité, pour obtenir en sortie du circuit comparateur (4) un signal de commande des moyens d'ajustement (7) de l'amplitude du signal modulant de façon à ajuster en permanence l'indice de modulation du signal modulé en fréquence produit à la sortie de l'oscillateur à la valeur de l'indice de modulation souhaité.

2. Dispositif selon la revendication 1, caractérisé en ce que le signal de commande appliqué sur l'entrée de commande de l'oscillateur à fréquence variable (5) est fourni par la sortie des moyens de commande (24) d'une boucle à verrouillage de phase/fréquence (6).

3. Dispositif selon les revendications 1 et 2, caractérisé en ce que le signal de consigne appliqué sur l'entrée de consigne de la boucle à verrouillage de phase (2) est obtenu par division par (p) de la f réquence ($F_S$) du signal obtenu en sortie de l'oscillateur a fréquence variable (5) au moyen d'un diviseur de fréquence (28).

4. Dispositif selon l'une quelconque des revendications 1 à 3, caractérisé en ce que le circuit comparateur (4) comprend un filtre (15), un amplificateur (16) et un dispositif de redressement, reliés en série,à l'entrée d'un comparateur (19) pour comparer le niveau de tension obtenu à la sortie du dispositif de redressement a un niveau de tension de référence correspondant à l'indice de modulation souhaité.

5. Dispositif selon l'une quelconque des revendications 1 à 4, caractérisé en ce que le signal modulant ajouté au signal de commande de l'oscillateur résulte de l'addition de deux signaux modulants de fréquences respectives $f_0$ et $f_1$ telles que la fréquence $f_0$ soit supérieure à la valeur maximum que peut prendre la fréquence $f_1$ et en ce que la fréquence de coupure de la boucle à verrouillage de phase 2 est réglée de manièrea être supérieure à la valeur maximum de la fréquence $f_1$ et inférieure à la fréquence $f_0$ pour que le signal filtré en fréquence obtenu en sortie de la boucle à verrouillage de phase (2) soit débarrassé de la fréquence de modulation $f_0$ et en ce que le signal de référence appliqué sur l'entrée du circuit comparateur (4) correspond à l'indice de modulation souhaité de la modulation en fréquence de l'oscillateur (5) par le signal de fréquence $f_0$.

## Patentansprüche

1. Vorrichtung zur automatischen Linearisierung der Frequenz-Steuersignal-Charakteristik eines mit variabler Frequenz arbeitenden, frequenzmodulierten Oszillators (5), worin die Arbeitsfrequenz des Oszillators erhalten wird aus einem Steuersignal, das an den Steuereingang des Oszillators angelegt wird, und die Modulationsfrequenz erhalten wird aus einem modulierenden Signal, dessen Amplitude durch Einstellmittel (7) eingestellt wird in Abhängigkeit vom Modulationsindex des gewünschten frequenzmodulierten Signals, wobei das modulierende Signal zu dem Steuersignal hinzugefügt wird, um am Ausgang des Oszillators ein frequenzmoduliertes Signal zu erhalten, dadurch gekennzeichnet, daß sie eine phasenstarre Schleife (2) umfaßt, an deren Regeleingang ein Signal angelegt ist, welches dem vom Oszillator (5) gelieferten frequenzmodulierten Signal entspricht, und deren Durchlaßband derart eingestellt wird, daß an ihrem Ausgang ein in der Frequenz gefiltertes Signal erhalten wird, das dem frequenzmodulierten Signal entspricht, welches an den Regeleingang angelegt ist, jedoch von der Modulationsfrequenz befreit, einen Phasendemodulator (3) enthält, dessen erster Eingang an den Regeleingang und dessen zweiter Eingang an den Ausgang der phasenstarren Schleife angeschlossen ist, um ein Signal zu erzeugen, welches dem Modulationsindex des frequenzmodulierten Signals entspricht, das am Ausgang des Oszillators (5) erhalten wird, sowie eine Komparatorschaltung (4) aufweist, deren erster Eingang an den Ausgang des Phasendemodulators (3) angeschlossen ist und an dessen zweiten Eingang ein Referenzsignal VREF angelegt ist, welches dem gewünschten Modulationsindex entspricht, um am Ausgang der Komparatorschaltung (4) ein Steuersignal zur Steuerung der Mittel (7) zur Einstellung der Amplitude des modulierenden Signals zu erhalten, so daß der Modulationsindex des frequenzmodulierten Signals, welches am Ausgang des Oszillators erhalten wird, dauernd auf den Wert des gewünschten Modulationsindex eingestellt wird.

2. Vorrichtung nach Anspruch 1, dadurch gekennzeichnet, daß das an den Steuereingang des mit variabler Frequenz arbeitenden Oszillators (5) angelegte Steuersignal vom Ausgang der Steuermittel (24) einer Phasen/Frequenzstarren Schleife (6) geliefert wird.

3. Vorrichtung nach den Ansprüchen 1 und 2, dadurch gekennzeichnet, daß das Regelsignal, welches an den Regeleingang der phasenstarren Schleife (2) angelegt ist, durch Teilung der Frequenz (F) des am Ausgang des mit variabler Frequenz arbeitenden Oszillators (5) erhaltenden Signals mittels eines Frequenzteilers (28) durch (p) erhalten wird.

4. Vorrichtung nach einem der Ansprüche 1 bis 3, dadurch gekennzeichnet, daß die Komparatorschaltung (4) ein Filter (15), einen Verstärker (16) und eine Gleichrichtervorrichtung enthält, welche in Serie geschaltet und mit dem Eingang eines Komparators (19) verbunden sind, um den am Ausgang der Gleichrichtervorrichtung erhaltenen Spannungspegel mit einem Referenzspannungspegel zu vergleichen, welcher dem gewünschten Modulationsindex entspricht.

5. Vorrichtung nach einem der Ansprüche 1 bis 4, dadurch gekennzeichnet, daß das modulierende Signal, welches dem Oszillator-Steuersignal hinzugefügt wird, aus der Addition von zwei modulierenden Signalen resultiert, deren Frequenzen $f_0$ und $f_1$ sind, dergestalt, daß die Frequenz $f_0$ größer ist als der Maximalwert, den die Frequenz $f_1$ annehmen kann, und daß die Trennfrequenz der phasenstarren Schleife 2 derart eingestellt wird, daß sie größer ist als der Maximalwert der Frequenz $f_1$ und kleiner ist als die Frequenz $f_0$, damit das in der Frequenz gefilterte Signal, welches am Ausgang der phasenstarren Schleife (2) erhalten wird, von der Modulationsfrequenz $f_0$ befreit ist, und daß das an den Eingang der Komparatorschaltung (4) angelegte Referenzsignal dem gewünschten Modulationsindex für die Frequenzmodulation des Oszillators (5) durch das Signal der Frequenz $f_0$ entspricht.

## Claims

1. Device for the automatic linearizing of the frequencycontrol signal characteristic of a variable frequency oscillator (5) which is frequency modulated, wherein the operating frequency of the oscillator is obtained from a control signal applied to the control input of the oscillator and the modulation frequency is obtained from a modulating signal the amplitude of which is adjusted by adjustment means (7) as a function of the modulation index of the desired frequency modulated signal, the modulating signal being added to the control signal for obtaining a frequency modulated signal at the output of the oscillator, characterized in that it comprises a phase locked loop (2) having a control input whereto a signal is applied which corresponds to the frequency modulated signal supplied by the oscillator (5), and the pass band of which is adjusted to obtain a frequency filtered signal on its output corresponding to the frequency modulated signal applied to the control input, but wherein the modulation frequency is removed, a phase demodulator (3) having first and second inputs coupled to the control input and to the output of the phase locked loop, respectively, for generating a signal corresponding to the modulation index of the frequency modulated signal obtained at the output of the oscillator (5), as well as a comparator circuit (4) having a first input coupled to the output of the phase demodulator (3) and a second input whereto a reference signal VREF is applied corresponding to the desired modulation index, for obtaining, at the output of the comparator circuit (4) a control signal for controlling the means (7) for the adjustment of the amplitude of the modulating signal, in a manner to continuously adjust the modulation index of the frequency modulated signal produced at the output of the oscillator to the value of the desired modulation index.

2. Device according to claim 1, characterized in that the control signal applied to the control input of the variable frequency oscillator (5) is supplied by the output of the control means (24) of a phase/frequency locked loop (6).

3. Device according to claims 1 and 2, characterized in that the control signal applied to the control input of the phase locked loop (2) is obtained by dividing by (p) the frequency ($F_S$) of the signal obtained at the output of the variable frequency oscillator (5) by means of a frequency divider (28).

4. Device according to any of claims 1 to 3, characterized in that the comparator circuit (4) comprises a filter (15), an amplifier (16) and a rectifier device which are connected in series and to the input of a comparator (19) for comparing the voltage level obtained at the output of the rectifying device to a reference voltage level corresponding to the desired modulation index.

5. Device according to any of claims 1 to 4, characterized in that the modulating signal added to the control signal of the oscillator results from adding two modulating signals of the frequencies $f_0$ and $f_1$, respectively, such that the frequency $f_0$ exceeds the maximum value which the frequency $f_1$ can assume, and in that the cut off frequency of the phase locked loop (2) is adjusted in a manner to exceed the maximum value of the frequency $f_1$ and to be less than the frequency $f_0$ so that the frequency filtered signal obtained at the output of the phase locked loop (2) is relieved from the modulation frequency $f_0$, and in that the reference signal applied to the input of the comparator circuit (4) corresponds to the desired modulation index of the frequency modulation of the oscillator (5) by the signal of the frequency $f_0$.

Fig.1

Fig.2